# EUROPEAN PATENT APPLICATION

(11) **EP 0 550 910 A1**
(43) Date of publication of application: **14.07.1993**
(21) Application number: 92122100.8
(22) Date of filing: 29.12.1992
(51) Int. Cl.: H01L 23/64, H01L 23/522

(54) **Advanced low RC multi-level interconnect technology for high performance integrated circuits**

(30) Priority: 31.12.1991 US 816456
(71) Applicant: TEXAS INSTRUMENTS INCORPORATED, Dallas Texas 75265 (US)
(72) Inventor: Moslehi, Mehrdad M., Dallas, Texas 75248 (US)
(74) Representative: Schwepfinger, Karl-Heinz, Dipl.-Ing.

(57) **Abstract**

A novel "low-RC multi-level interconnect" technology has been conceived for advanced sub-0.5 µm silicon technologies. The proposed process has a number of significant characteristics: (i) compatible with various metal systems (Al, Cu, W, etc.), (ii) "air-gap" interlevel dielectrics; (iii) compatible with standard fabrication processes, (iv) excellent mechanical stability; and (v) compatible with hermetically sealed packaging techniques. Compared with a Al-based advanced interconnect technology, the new interconnect system can reduce the RC delay by a factor of 6. The impacts are major chip performance improvements such as lower power dissipation and higher operation frequencies. This technology extends the air-gap technique well into the Si domain and is a technology scaling enabler.

## Description

### BACKGROUND OF THE INVENTION

Interconnect parasitic resitance and capacitance elements will become the most significant problem as the semiconductor technologies (Complementary Metal Oxide Semiconductor (CMOS), Bipolar, Bipolar Complementary Metal Oxide Semiconductor (BiCMOS) scale below 0.5 micrometers. The parasitic resitance and capacitance elements associated with the Al-based (or refractory metal-based) metallization systems can degrade the chip performance due to the RC delays. Moreover, these interconnect parasitc elements increase the overall chip power dissipation and increase the possiblility of signal cross talk. As a result, conception and development of the so called low RC interconnect technologies will be among the most important and critical enablers for scaling down advnaced semiconductor technologies well below .05 micrometers.

### Prior Art Solutions

It is clear that the low RC interconnect systems require either low-resistance metal lines or low-permitivity dielectrics, or preferably both together. Most of the prior art to date have focused on development of low-resistance metallization systems. These include:

Copper metallization by physical vapor deposition, PVD, chemical vapor deposition (CVD), or electroless deposition (P=1.7 µΩ cm.)

Gold metallization by electroless deposition or other techniques.

Low temperature such as liquid nitrogen (77k) aluminum (Al) based metallization systems (4-5 reduction in Al resistivity at 77k compared to 25°C).

Superconducting transmission line interconnects.

Despite all these alternatives metal interconnect systems, room temperature Al-based interconnects are the dominant metallization systems.

Very little development work has been done in the area of low permitivity dielectrics for integrated circuit (IC) metallization. Silicon Dioxide (Si₁O₂) has been the dominant interlevel dielectric material used in silicon (Si) IC technologies. Moreover, some high-speed galium arsenide (GaAs) technologies have employed air bridges in order to reduce the device interconnection delay. However, the conventional air bridge techniques are not usually compatible with advanced silicon (Si) IC's with multiple metal levels and hermetically sealed packages.

As a result, there is a need for a manufacturable low-RC interconnect technology compatible with standard Si-based technologies and hermatically sealed packages. The low-RC interconnect technology must he easily applicable to advanced semiconductor technologies with multiple planarized layers of metals (e.g. 3 or more). The overall back-end manufacturing yield and chip reliability must be at least as good as those of standard techniques.

### BRIEF DESCRIPTION OF THE DRAWINGS

Figures 1 through 2a, 3 through 9 and 13 through 23 illustrate cross-sectional views of a structure fabricated according to the processing steps described herein.

Figure 2b illustrates the mask pattern for use of negative image 1 superimposed under the mask pattern for negative image 2. Negative image referring to the use of a dark field mask in conjunction with positive photoresist.

Figures 10 and 11 illustrate diagrams representative of a cross-section of a structure formed from the process steps described herein.

Figure 24 illustrates a top view of the grid for the nitride overlayer superimposed on top of the hexagonal nitride support structure prior to a passivation overlayer sealing process.

### DETAILED DESCRIPTION OF THE INVENTION

The invention allows formation of air gaps (εᵣ = 1) interlevel dielectrics between adjacent metal levels and a multi-level metallization system. The metal lines can be made of any suitable conductive material such as Al, tungsten (W), copper (Cu), gold (Au), etc. The metallization system of this invention will offer excellant mechanical stability and overall reliability. The fabrication process complexity is fairly comparable to the conventional metallization techniques. The process flow described in the following will be based on the use of copper metallization (formed by chemical vapor deposition (CVD), However, the multi-level metallization fabrication flow is fully compatible with any metal material system. Due to its low electrical resitivity (1.7 µΩ cm. for Cu vs 2.7 µΩ cm. for Al), copper will be the preferred material for advanced sub-0.5 µm CMOS/BiCMOS and bipolar technologies. The combination of copper metallization with the air-gap interlevel dielectric of this invention can reduce the RC interconnect delay by as much as 2.7/1.7 x 3.9 = 6 times (compared to the existing Al-based multi-level metallization systems). It should be noted that the impace of the air-gap interlevel dielectric technology of this invention on RC reduction is much larger than that of replacing Al with copper. Besides interconnect RC related delay reduction, the interconnect technology of this invention will also reduce the overall chip power dissipation and signal cross talk (both level-to-level and inplane cross talk (x-talk)) by significant factors.

### Assumptions for the Following Fabrication Flow

1. Copper is used as metal (other metals may also be used).
2. Silicon Nitride is used as a passavation/encapsulation layer on copper.
3. Silicon Oxide (doped, undoped, or a combination thereof) is used as a disposable interlevel dielectric (Single Crystal Si or polysilicon may also be used as a disposable interlevel material).
4. Silicon Nitride is used as a interlevel mechanical support material (silicon dioxide may also be used for mechanical support if a material such as silicon is used as a disposable interlevel material).
5. The process employee a well-established planarization technique such as phosphosilicate glass (PSG)/borophosphosilicate glass (BPSG) reflow and/or resist etch-back.

### Preferred Process Flow

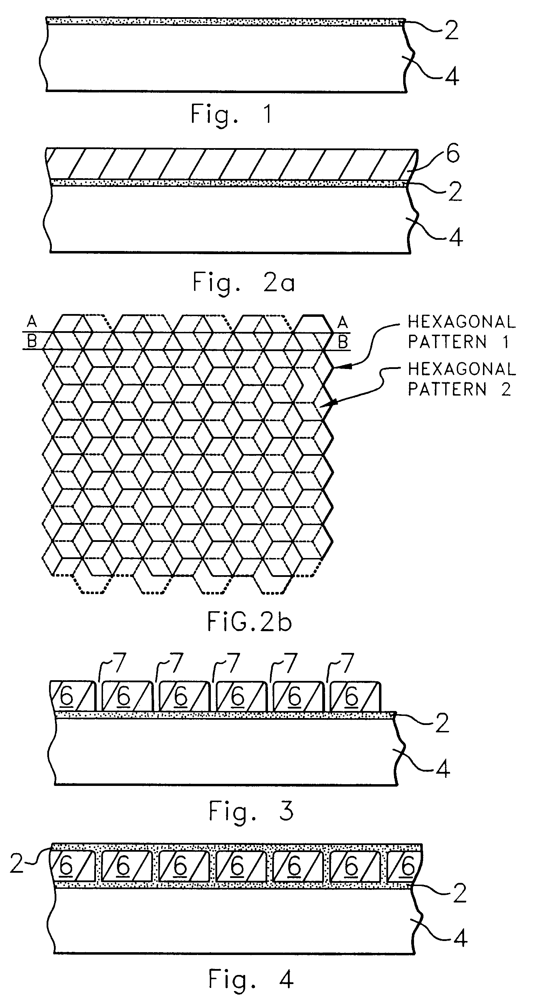

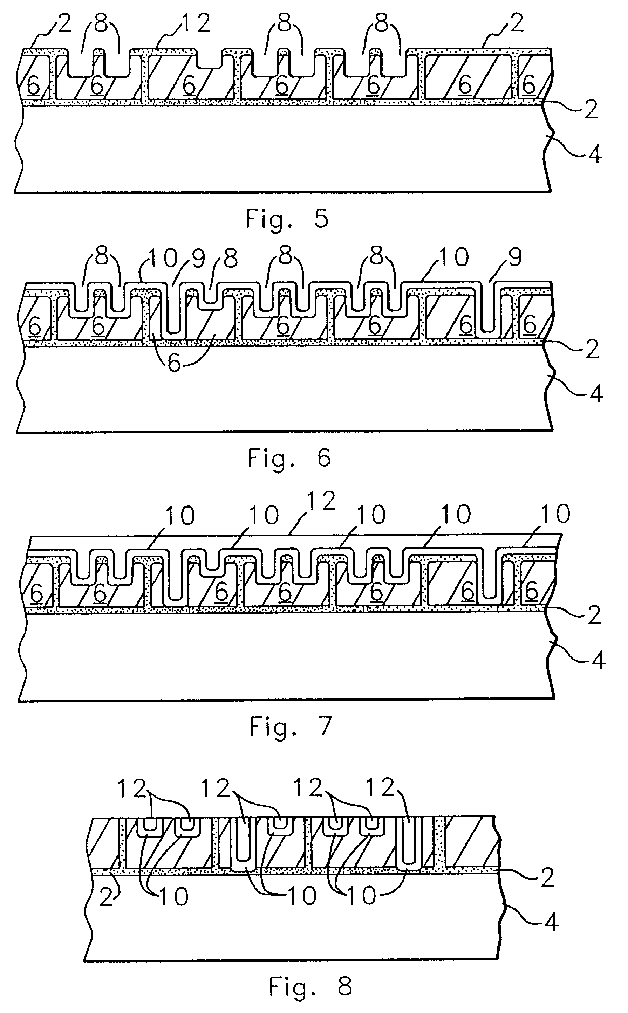

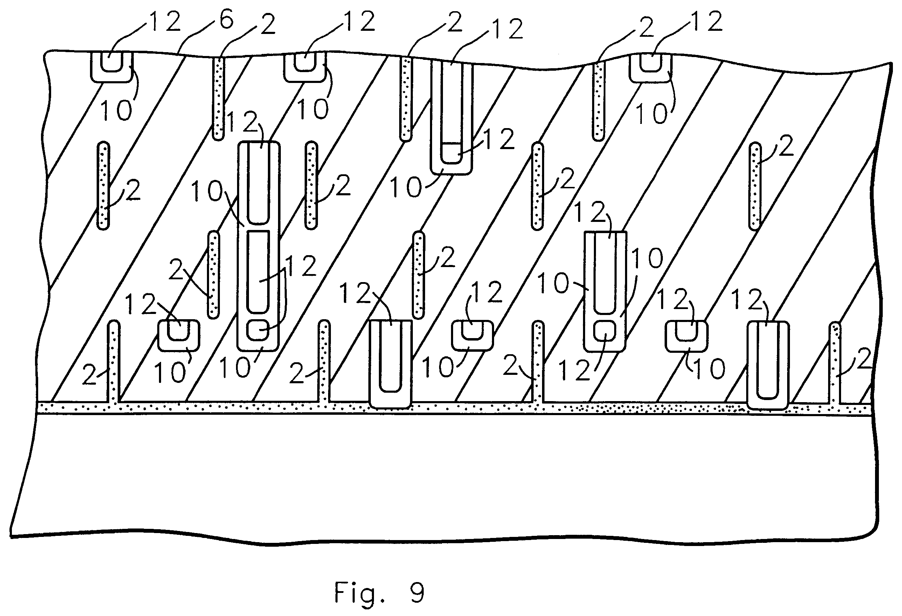

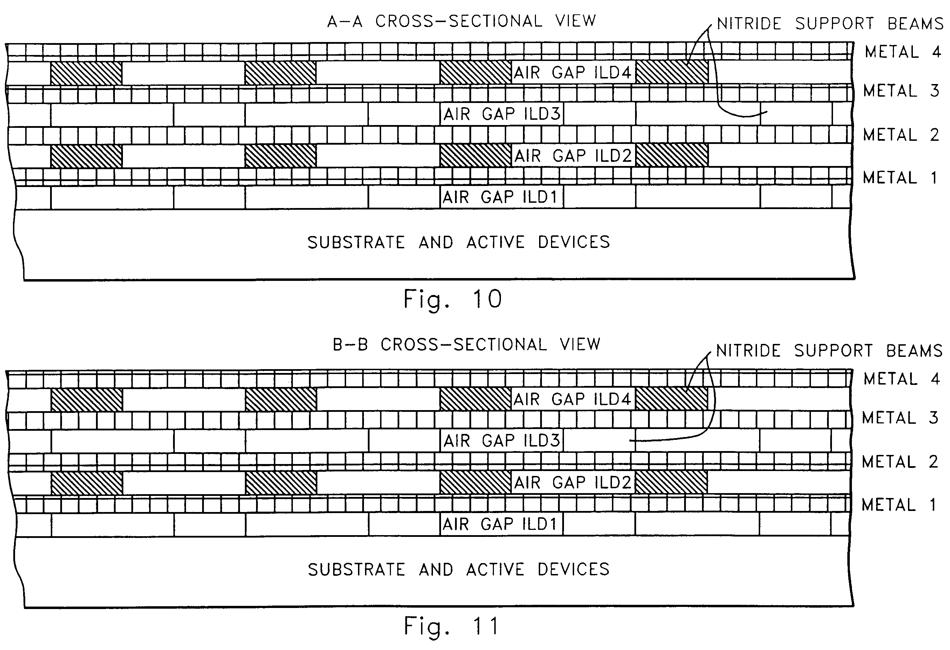

This process flow shall be described under the assumption that copper is used as the metal material (exactly the same flow can be used with Al based metals).
1. With reference to figure 1, a cross-sectional view of the resulting structure from the following processing steps, complete the fabrication flow up to the transistor level 2. This includes metal 0, (the first metal layer) local interconnects, etc.
2. With reference to figure 2, a cross-sectional view of the resulting structure from the following processing steps, deposit a thin (e.g. 1000-2000 Å) layer of silicon nitride (low pressure chemical vapor deposition, LPCVD, plasma enhanced chemical vapor deposition, PECVD, or photochemical) on substrate 4. This will act as an etch stop layer later on to protect field oxide, oxide spacers, and etc.
3. With reference still to figure 2a, deposit planarized interlevel oxide dielectric 1 (ILD1). This can be done by a low temperature ECR deposition (in-situ planarized), or conventional LPCVD/PECVD with resist etch back planarization The overall ILD1 thickness is made to be around 1-2 µm. Perform a microlithography process step (i.e., spin on resist and prebake resist).
4. Use the mask for negative imaging of hexagonal pattern 1 (shown in figure 2b) and pattern the photoresist. Perform anisotropic oxide etch using optical end-point detection. Stop the plasma etch process using the nitride underlayer as etch stop (adjust over etch based on optical emission end-point). Strip the photoresist layer. The resulting structure is shown in figure 3 which illustrates a cross-sectional view of the resulting structure.
5. Perform conformal silicon nitride deposition using a low temperature low pressure chemical vapor deposition (LPCVD) or plasma enhanced chemical vapor deposition (PECVD) process. A good example is ECR (electron cyclotron resonance) plasma deposition. This will fill the trenches (hexagonal trenches) and leave nitride 2 on that surface as shown in figure 4 which illustrates a cross-sectional view of the resulting structure. Perform a microlithography step.
6. As shown in figure 5, a drawing showing a cross-sectional view of the resulting structure from use the metal 1 mask (negative image as shown in figure 2b) and pattern the photoresist. Perform a timed anisotropic plasma etch (nitride/oxide) in order to form approximately 0.5-1 µm deep trenchs 8 in the interlevel oxide dielectric ILD1. These trenches 8 will contain the final metal 1 structure. Strip the photoresist. Perform a micro-lithography step.
7. Use a via 1 (metal 1-to metal 0) mask (mask for forming a via) and pattern the photoresist. Perform anisotropic plasma nitride/oxide/nitride etch to open the contact holes. Via 9 is shown in the drawing of figure 6 which illustrates a cross-sectional view of the resulting structure.
8. As shown in figure 6, deposit a conformal nucleation/glue layer of a suitable material (e.g. TiN, TI, Cr, etc.) by chemical vapor deposition (CVD) or physical vapor deposition (PVD). The layer should result in being approximately 250 to 1000 A thick.
9. As shown in figure 7, a drawing illustrating a cross-sectional view of the structure resulting from the following processing steps, deposit a blanket layer of copper (P=1.7 µΩ cm.) by CVD. Make the deposition thickness approximately 0.5 µm. This will fill the via holes and dielectric trenches and will result in fairly planar surface copper.
10. Perform a blanket anisotropic copper etch back using a suitable RIE (e.g. hot RIE using chlorine environment) or sputter etch process. Time the etch process with suitable over etch using an optical end-point detection (surfacce reflectance will change abruptly when the glue layer on flat surface is exposed). Then perform an anisotropic plama etch back to remove the exposed glue layer. Perform a selective isotropic plasma nitride etch to remove the exposed nitride layer from the top surface. The resulting structure is illustrated in figure 8.
11. Deposit the second interlevel oxide dielectric (ILD2) to the required thickness by LPCVD or PECVD. No additional planarization process may be required because the metal 1/ILD1 surface is already planar. A low temperature deposition process (e. g. T≦ 300°C) with plasma is preferred. Deposit a thin (e.g. 1000 Å) silicon nitride layer by PECVD.
12. Repeat steps 4 through 10; however, this time use the mask for negative image of hexagonal pattern 2 (shown in figure 2a). The metal and via patterning steps should employ the metal 2 and via 2 (metal 2 to metal 1) masks.
13. Deposit a thrid interlevel oxide dielectric, (ILD3).
14. Repeat steps 4 through 10. Use the mask for negative image of hexagonal pattern 1 (shown in figure 2a). Moreover, the metal and via pattening step should employ the metal 3 and via 3 (metal 3 to metal 2) masks.
15. Deposit a fourth interlevel oxide dielectric, (ILD4).
16. Repeat steps 4 through 10. Use the mask for negative image of hexagonal pattern 2 (shown in figures 2b). Moreover, the metal and via patterning steps should employ the metal 4 and via 4 (metal 4 to metal 3) masks. A cross-sectional view of the resulting structure obtained using steps 11 through 16 is illustrated in figure 9.
17. Perform a timed wet HF or vapor-phase HF process. This will selectively remove old the interlevel oxide dielectric layers in the multi-level interconnect structure without removing the hexagonal nitride structures and without attacking the metal structure. Diagrams representative of a cross-section of a structure formed from the foregoing process steps are illustrated in figures 10 and 11. The cross-section represented in figure 10 is along lines A-A as illustrated in figure 2b. The cross-section represented in figure 11 is along lines B-B as illustrated in figure 2b.

### Alternative Process Flow for Multilevel Metallization

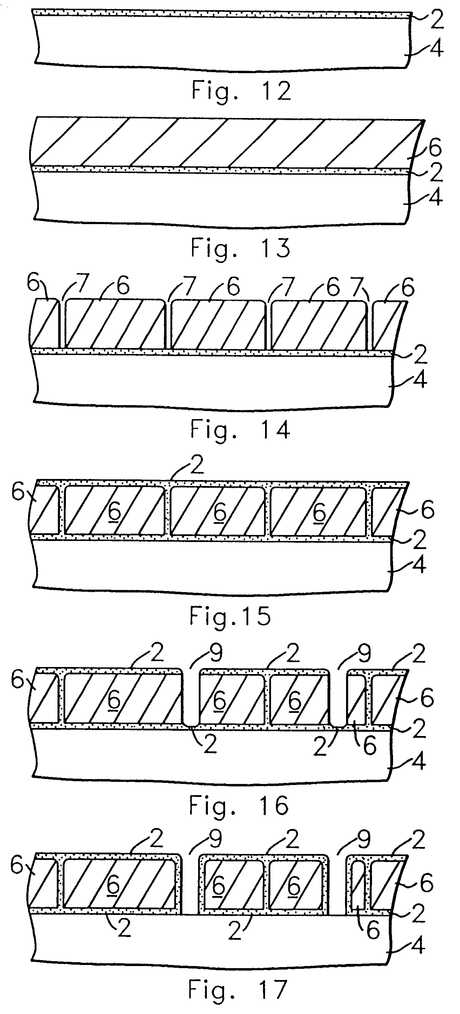

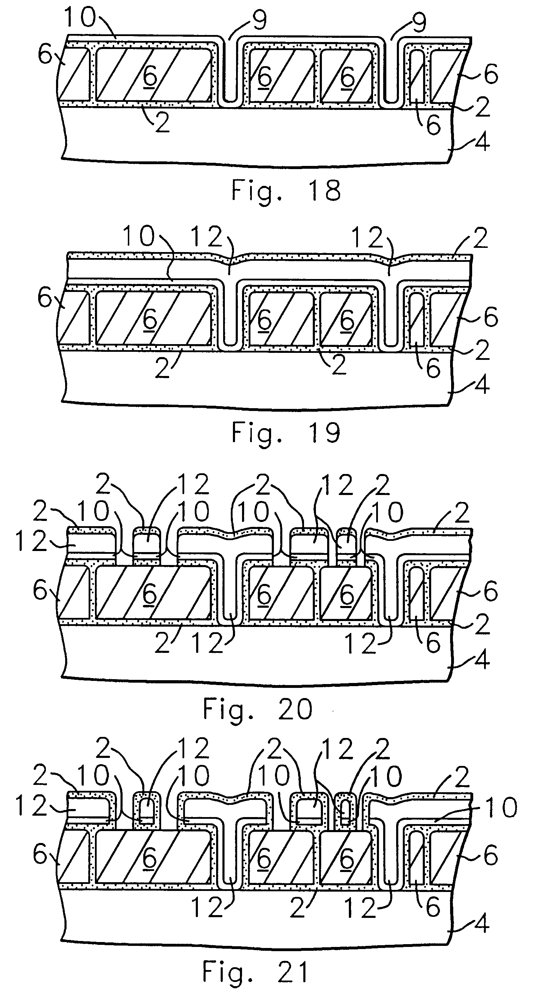

The following discloses an alternative process for multilevel metallization. Element labels are referenced throughout and correspond to figures 12 through 23 which represent sequential cross-sectional views of the resulting structure obtained from successive processing steps.
1. Complete the device fabrication process flow up to the transistor level (assume the process is for CMOS devices with silicided gate and source drain regions). The process flow may employ conventional transistor level silicide interconnects as well as silicide or metal nitride local interconects.
2. Deposit a layer (e.g. 1000 - 2000 Å) of silicon nitride, preferably by plasma enhanced chemical vapor deposition (PECVD) or photochemical processing. LPCVD may also be used. A buffer layer (underlayer) of silicon dioxide may be used prior to the nitride deposition. An optional layer of a single crystal Si or polysilicon (approximately 1000 Å) may be deposited on nitride (etch stop).
3. Deposit the interlevel LPCVD and/or PECVD oxide dielectric (undoped, doped PSG/BPSG, and etc) 6. If necessary, use glass reflow and/or resist etch back to planarize the surface (approximately 1µm oxide). Perform a microlithography process step.
4. Use the mask for negative image of "hexogonal pattern 1 (shown in figure 2b) The hexagonal unit cell has diametric dimension which may be in the range of approximately 10 to 100 µm. The hexagonal linewidth can be selected to be as small as the minimum feature size and as large as several times larger than the minimum feature size (e.g. 0.35 - 1 µm for 0.35 µm technology; smaller herewith is preferred). Pattern the photoresist.
5. Perform anisotropic plasma oxide etch. Stop on the bottom etch-step layer (nitride or silicon/nitride bilayer). Strip the resist. This will result in vertical trenches with a hexagonal unit cell pattern as shown in drawing of figure 2b.
6. Perform low pressure chemical vapor deposition (LPCVD) nitride (comformal PECVD nitride such as a remote plasma deposition may also be used). Make the deposited nitride thicknes at least more than 1/2 of the trench width. This will result in complete filling of the vertical interlevel trenches with nitride. Moreover, a nitirde layer covers all the flat surfaces. For instance, for 0.50 µm wide trenches, 3000 Å nitride will be deposited in order to completely fill the trenches. Perform a microlithography process step.
7. Use the via (metal 1-to-metal 0) mask and pattern the photoresist. Perform plasma oxide etching to open the via holes 9 (also referred to as vias) down to the lower Si₃ N₄ layer which acts as an etch stop.
8. Deposit a thin (approximately 250 to 500 Å) nitride layer 20. Perform a RIE (reactive ion etch) step to remove this nitride from the bottom of open via holes. This etch will remove some fraction of the nitride from top surfaces but at least approximately 1000 Å will remain (even with 50 to 100 % over etch). The nitride will remain on via sidewalls and will encapsulate the via plugs.
9. Deposit a nucleation and glue layer 22 such as TiN or pure titanium (Ti) by CVD or physical vapor deposition (PVD).
10. Deposit a blanket layer of copper 24 by CVD. This will fill the via holes and form a blanket layer (e.g. 6000 Å) on flat furfaces.
11. Deposit a layer of silicon nitride by LPCVD or PECVD (approximately 2500 Å).
12. Use the metal 1 mask and pattern the photoresist and etch pattern into top nitride. Strip resist. Transfer the pattern into copper by anisotropic etch using a process such as high-T (approximately 250°C). RIE in a silane silane/amonia/chlorine (SiH₄/NH₄/CL₂) plasma. Continue to etch through the underlayer of glue (TiN) by a suitable etch process. Continue the etch by removing the exposed nitride layer from bottom surface. This will still leave a fraction of nitride on top of the metal line.
13. Perform LPCVD or PECVD nitride process for conformal depositin of silicon nitride (approximately 250 to 500 Å). Then perform an RIE process to remove excess silicon nitride from bottom flat surfaces. The copper interconnect lines are now fully encapsulated in silicon nitride.
14. Deposit the second interlevel oxide and perform planarization by resist etchback, as required.
15. Go to step 4. However, this time use the mask for negative imaging of hexagonal pattern 2 (shown in figure 2b) which has hexagonal unit cells with displaced position with respect to the hexagonal pattern 1 on the lower level.
16. Proceed with steps similar to those previously described in steps 5 through 13 using the via 2 and metal 2 masks. These will result in formation of metal 2 to metal 1 via plugs and metal 2 interconnects.
17. Repeat step 4 with the mask for negative imaging of hexagonal pattern 1. Then repeat step 16 with the via 3 and metal 3 masks. These will result in formation of metal 3 to metal 2 via plug and metal 3 interconnects.
18. Repeat step 4 with the mask for negative image of hexagonal pattern 2. Then repeat step 16 with the via 4 and metal 4 masks. these will result in formation of metal 4 to metal 3 via plug, and metal 4 interconnects. In this example, metal 4 is the last interconnect level.
19. Perform a wet HF or vapor-phase HF process. This will remove all the interlevel oxide dielectric layers in the entire multilevel interconnect structure. The etch process is highly selective to oxide removal and will remove only a very small amount of the exposed nitride structure. The result of this process is a fully encapsulated multilevel copper interconnect structure (with silicon nitride encapsulation). The interconnect structure is mechanically supported by multilevel hexagonal nitride cells. The interlevel dielectrics are air gaps. Diagrams representative of a cross-section of a structure formed from the foregoing process steps are illustrated in figures 10 and 11.

Note that the last step will not attack or remove any exposed material layers other than the interlevel oxide dielectrics. The transistor level including field oxide is protected by the remaining nitride layer on the active devices.

### Formation of Continuous Passivation Overlayer of Nitride and Hermetically Sealed Chip Packages

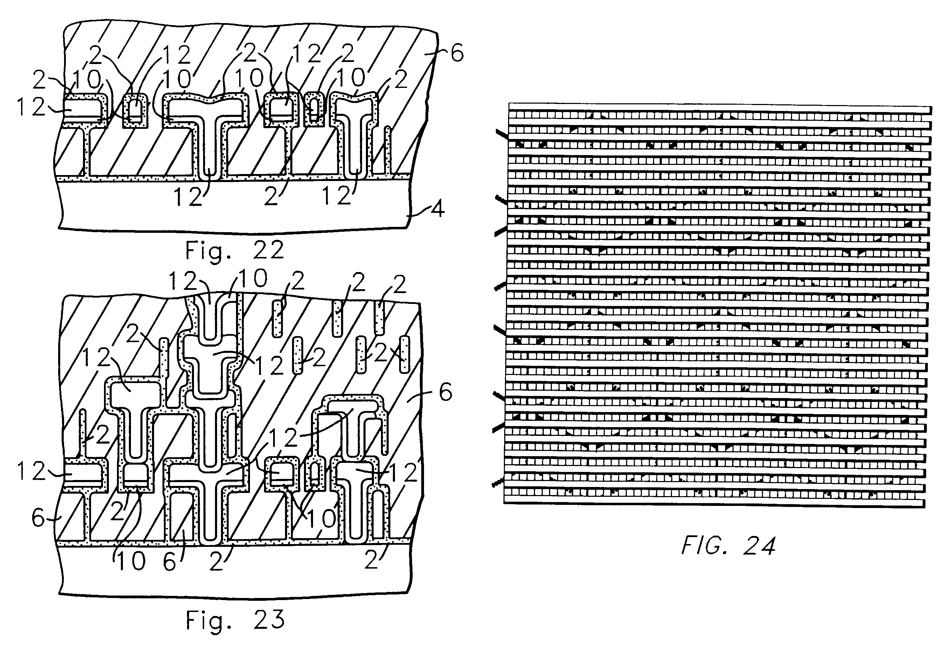

The formation of passivation overlayer and hermatically sealed packages for chips with using the air gap dielectric multilevel interconnect technology of this invention is also contemplated herein. Consequently, a simple technique is proposed in order to form a continuous passivation overlayer of nitride or silicon oxynitride in any of the two previously discussed fabrication flows. This passivation overlayer is required in order to form the bonding pad openings and to protect the chip against environmental and contamination sources. This process module is added to the original interconnect fabrication flow or to the simplified/preferred flow before the last wet HF or vapor-phase HF step. The protective overcoat (P.O.) layer formation, pad opening, and hermetic packaging procede as follows:
A) Deposit a relatively thick (0.5-1µm) layer of silicon nitride (or oxynitride, nitride is preferred) by LPCVD or PECVD (low-temperature PECVD is preferred). This is done after formation of the topmost metal level (after step 19/before step 20 in the original flow; after step 16 and before step 17 in the simplified flow).
B) Use the P.O. mask and pattern photoresist to open the area corresponding to the bonding pads and also to open a grid-type structure, similar to that shown in figure 24. Figure 24 illustrates a top view of the grid for the nitride overlayer superimposed on top of the hexagonal nitride support structure prior to a passivation overlayer sealing process. The openings in the grid structure have minumum size dimensions (e. g. 0.35 µm for 0.35 µm technology). For simplicity, assume the lines and spaces all have minimum feature dimensions (0.35 x 0.35 µm² grid squares). Then perform anisotropic nitride etch to transfer the pattern from photoresist into nitride P.O. layer. Strip the photoresist. Note that many grid openings fall on top of each hexagonal cell.
C) Perform a timed wet HF or vapor-phase HF etch process (previously step 20 in the original flow and step 17 in the preferred/simplified flow). This will remove oxide from the entire multi-level metal structure without attacking the nitride structures (hexagonal-array beams, top patterned nitride, etc.) and without attacking the metal structures. The grid structure on top nitride allows complete etch access to all ILD layers. The post-etch structure has full mechanical stability.
D) Perform a conformal (preferably low-temperature) silicon nitride deposition by LPCVD or PECVD (e.g. ECR plasma deposition). This layer may also be oxynitride. Adjust the deposition time to make the thickness lager than 1/2 of the grid opening (e.g. 0.2 µm thick for 0.35 µm grid openings). This conformal deposition will form a thin conformal passivation layer coating of nitride or oxynitride (approximately 0.2 µm thick) on all the multi-level metal structures including the metal lines and via plugs. It also completely seals the top P.O. nitride grid openings due to sidewall deposition. A thin layer of nitride (∼0.2 µm) is also deposited on the top flat surfaces, including the exposed bonding pads.
E) Perform a timed isotropic plasma nitride etch to remove approximately 0.2-0.3 µm silicon nitride. This will again expose the bonding pads but will not remove the P.O. nitride layer. Only 0.2 - 0.3 µm of the P. O. nitride is removed. As a result, 0.5 - 1 µm P. O. nitride layer (fully sealed) will remain on the top of the entire structure (with the exception of the bonding pads).
F). Connect the bonding pads.
G.) Proceed with a process to fabricate the hermatically sealed packaged chip. Note that this process can be done in a controlled ambient such as air or nitrogen. The space or gaps in the multi-level metal structure can be filled with a suitable gas (with a high breakdown field) at atmospheric, low, or above atmospheric pressures.
Note the following:
1. This process does not employ any additional mask to complete the top P. O. nitride sealing process. The P.O. mask is also used to form the grid structure on the P.O. layer. The grid is initially used to perform the selective oxide removal process and is finally sealed by another conformal nitride deposition step.
2. Gas breakdown - The structure must be designed to prevent gas breakdown between metal layers in the structure. The dielectric breakdown of air at atmospheric pressures is ∼ 31 kv/cm. (3.1 V/µm). At atmospheric pressure, the dielectric breakdown of CO₂ is higher than air by a factor of 1.2. for N₂ this factor is 1.16. The dielectric strenghs of gases increases with pressure. At a pressure of 2 - 3 atmospheries, N₂ has a dielectric strengh which is ∼1.15 x larger than that of air. As a result, the preferred method of hermetic packaging is in a high-pressure controlled N₂ environment. The pressure may be in the 1 - 5 atm (or even higher) range. This will prevent micro-discharge in themulti-level metal structure with N₂ filled space.

It is preferred not to use rough vacuum space in the multi-level metal structure. This is due to the fact that if vacuum-sealed packaged chip may be suceptible to field-induced electron emissions. However, good vacuum can provide a dielectric breakdown field as high as 5.4 MV/cm. (tunneling will happen above these fields).

Therefore, the preferred choices of gas dielectric medium are the following:
1. High-pressure (e.g. 1 - 5 atm)N₂
2. High vacuum (P≦ 10⁻⁶ torr).

Considering these provisions, gas breakdown in the metal structure will not be a problem.

Although the invention has been described in detail herein with reference to preferred embodiments and certain described alternatives, it is to be understood that this description is by way of example only, and is not to be construed in a limiting sense. It is to be further understood that numerous changes in the details of the embodiments of the invention, and additional embodiments of invention, will be apparent to, and may be made by persons of oridnary skill in the art having refererence to this description. It is contemplated that all such changes and additional embodiments are within the sirit and true scope of the invention as claimed below.

## Claims

1. A process for forming a muli-level metallization structure on a integrated circuit formed on a substrate comprising:
(a) etching a layer of a first dielectric material according to a pattern of a plurality of islands lying in a plane;
(b) surrounding said islands with a second dielectric material;
(c) placing a patterned metal layer adjacent said first dielectric material;
(d) repeating steps (a) through (c) a predetermined number of times so as to offset the pattern of each sucessive layer of said first dielectric material; and
(e) etching away said first dielectric material.

2. A process as recited in claim 1 wherein each said island is hexagonally shaped.

3. A process as recited in claim 1 wherein said substrate is selected from the group of semiconductor materials consisting of silicon and galium arsenide.

4. A process as recited in claim 1 further comprising placing a passivation overlayer over said structure.

5. A process as recited in claim 4 wherein said passivation overlayer is formed by the steps comprising:
(a) placing a layer of a third dielectric material adjacent the last formed metallization layer;
(b) etching areas in said third dielectric material according to a patterning in a mask so as to etch areas in said third dielectric material corresponding to a grid and corresponding to bonding pad locations;
(d) selectively etching said first dielectric material;
(e) placing a conformal layer over the structure thus formed by the foregoing processing steps;
(f) etching said conformal layer so as to remove said conformal layer from a said bonding pads.

6. A process as recited in claim 5 which further includes the stops of:
(a) selectively connecting said bonding pads;
(b) fabricating a hermetically sealed package in a controlled ambient selected from the group consisting of air or nitrogen.

7. A process as recited in claim 1 wherein, prior to step (e), said patterned metal layer is provided within etched trenches and vias in said first dielectric material.

8. A process as recited in claim 1 wherein, prior to step (e), said patterned metal layer is provided adjacent a substantially planar surface of said first dielectric material.

9. A process as recited in claim 1 wherein said metal layer is selected from the group consisting of copper, aluminum, and tungsten.

10. A process as recited in claim 1 wherein a conformal glue layer abuts said metal layer.

11. A multilevel metallization structure comprising a substrate including a plurality of active devices adjacent a honeycombed shaped structure comprising metal layers supported by a dielectric material, said metal and dielectric material together encapsulating gas selected from the group consisting of air and nitrogen.
